# EUROPÄISCHE PATENTSCHRIFT

(11) **EP 1 219 034 B1**
(45) Veröffentlichungstag und Bekanntmachung des Hinweises auf die Patenterteilung: **26.03.2003**
(21) Anmeldenummer: 00969227.8
(22) Anmeldetag: 22.09.2000
(51) Int. Cl.: H03M 13/35, H03M 13/29, H04L 1/00

(54) **VERFAHREN UND VORRICHTUNG ZUR KANALKODIERUNG IN EINEM NACHRICHTENÜBERTRAGUNGSSYSTEM**
METHOD AND DEVICE FOR CHANNEL ENCODING IN AN INFORMATION TRANSFER SYSTEM
PROCEDE ET DISPOSITIF DE CODAGE DE VOIE DANS UN SYSTEME DE TRANSMISSION D'INFORMATIONS

(30) Priorität: 29.09.1999 DE 19946721
(43) Veröffentlichungstag der Anmeldung: 03.07.2002
(73) Patentinhaber: Infineon Technologies AG, 81669 München (DE)
(72) Erfinder: DILLINGER, Markus, 81737 München (DE); DOETSCH, Markus, 56072 Koblenz-Rübenach (DE); SCHMIDT, Peter, 82008 Unterhaching (DE); SCHULZ, Egon, 80993 München (DE); JUNG, Peter, 67697 Otterberg (DE); SCHNEIDER, Michael, 56823 Büchel (DE); PLECHINGER, Jörg, 80469 München (DE); MITJANA, Enric, 81379 München (DE); SCHINDLER, Jürgen, 81369 München (DE)
(74) Vertreter: Lange, Thomas, Dr.
(86) Internationale Anmeldenummer: DE0003348
(87) Internationale Veröffentlichungsnummer: WO01024382

(56) Entgegenhaltungen:
- EP-A- 0 749 211
- EP-A- 0 820 159
- WO-A-00/74295

## Beschreibung

Die Erfindung betrifft ein Verfahren zur Kanalkodierung in einem Nachrichtenübertragungssystem und eine Vorrichtung zur Durchführung des Verfahrens.

Zur Kanalkodierung in Nachrichtenübertragungssystemen, insbesondere in Mobilfunksystemen, wird zum Schutz von Symbolen eines zu übertragenden Informationsstromes, die verschiedenen Güteklassen angehören, ein ungleicher Fehlerschutz zur Erzielung einer entsprechenden Übertragungsqualität benötigt. Als Beispiel sei hier nur bei Mobilfunksystemen der zweiten Generation, wie beispielsweise dem GSM-Standard (Global System for Mobile Communications), der Vollratensprachdienst erwähnt, der für einen hohe Übertragungsqualität einen guten Fehlerschutz benötigt.

Bei Mobilfunksystemen nach dem GSM-Standard wird ein ungleicher Fehlerschutz durch Verwendung unterschiedlicher Kodes und durch deren Verkettung erreicht. Allerdings werden zur Dekodierung eine Vielzahl entsprechender Dekodierer zur Dekodierung der unterschiedlichen Kodes benötigt. Dies bedingt bei einer entsprechenden Schaltungsanordnung insbesondere einen großen Implementierungsaufwand.

In der europäischen Patentanmeldung EP 0 749 211 A2 ist ein Nachrichtenübertragungssystem dargestellt, in welchem ein Informationsstrom mit Symbolen unterschiedlicher Wichtigkeit mehreren parallel zueinander angeordneten Kodierzweigen zugeführt wird. Die Aufteilung der Informationssymbole erfolgt mittels Filtern, die eingangsseitig der Kodierzweige vorgesehen sind. Am Ausgang der Kodierzweige ist eine gemeinsame Multiplexereinheit angeordnet, welche die kodierten Teildatenströme zusammenfügt.

Die europäische Patentanmeldung EP 0 820 159 A2 zeigt ebenfalls eine Mehrzahl parallel angeordneter Kodierzweige, deren Ausgänge einem Multiplexer zugeleitet werden. Zur Aufteilung der Informationssymbole auf die Kodierzweige kann ein Demultiplexer vorgesehen sein. Ferner ist in dieser Schrift die Verwendung einer Punktiereinheit gezeigt, welche parallel zu dem Multiplexer geschaltet ist und die Einstellung einer gewünschten Koderate ermöglicht.

In der internationalen Patentanmeldung WO 00/74295 A1 ist ein Verfahren und eine Vorrichtung zur flexiblen Kanalkodierung beschrieben, bei welcher kein Demultiplexer am Eingang einer Parallelanordnung mehrerer Kodierzweige vorgesehen ist.

Aufgabe der vorliegenden Erfindung ist es, ein Verfahren zur Kanalkodierung in einem Nachrichtenübertragungssystem und eine Vorrichtung zur Durchführung des Verfahrens anzugeben, das bzw. die einen ungleichen Fehlerschutz bei der Kanalkodierung von zu übertragenden Symbolen über einen Nachrichtenkanal, insbesondere über einen Mobilfunkkanal, mit einem geringen Aufwand zur Dekodierung der Symbole ermöglicht.

Diese Aufgabe wird durch ein Verfahren mit den Merkmalen von Patentanspruch 1 und eine Vorrichtung mit den Merkmalen von Patentanspruch 6 gelöst. Bevorzugte Ausführungsformen der Erfindung sind Gegenstand der abhängigen Patentansprüche.

Die Erfindung betrifft ein Verfahren zur Kanalkodierung in einem Nachrichtenübertragungssystem, wobei
- ein zu kodierender Informationsstrom Symbole verschiedener Güteklassen aufweist,
- der Informationsstrom einer Vielzahl von Kodierzweigen zur Kodierung zugeführt wird,
- in jedem Kodierzweig mittels eines Demultiplexers die Symbole verschiedener Güteklassen des Informationsstromes eingespeist werden,
- mindestens einem der Demultiplexer ein Verschachteler zur Erzeugung eines Fehlerschutzes der Symbole nachgeschaltet ist,
- in jedem Kodierzweig die gegebenenfalls verschachtelten Symbole kodiert und die kodierten Symbole aus den Kodierzweigen parallel einer Punktierer- und Multiplexereinheit zugeführt werden, und
- mit der Punktierer- und Multiplexereinheit eine Koderate eingestellt wird.

Ein wesentlicher Punkt der Erfindung ist die Einteilung von Symbolen des zu kodierenden Informationsstroms in unterschiedliche Güteklassen, die der zu erzielenden Übertragungsqualität entsprechen, und eine entsprechende unterschiedliche Kodierung der Symbole, d.h. die Kodierung mit einer unterschiedlichen Koderate (die Koderate gibt das Verhältnis von Informationsdaten zu Informationsdaten und Prüf- bzw. Korrekturdaten an). Bei einer hohen Güteklasse von Symbolen entsprechend einer hohen Übertragungsgualität wird in dem dafür vorgesehenen Kodierzweig mit besonders hohem Fehlerschutz, d.h. mit einer besonders niedrigen Koderate, kodiert. Der Punktierer- und Multiplexereinheit wird der Informationsstrom bei dem erfindungsgemäßen Verfahren parallel zugeführt, so daß diese die Systematik des Informationsstromes kennt und dann die unterschiedlich kodierten und fehlergeschützten Symbole aus den einzelnen Kodierzweigen, die eine unterschiedliche Koderate aufweisen, derart verarbeitet, daß die unterschiedlichen Koderaten durch Punktierung an die Übertragungsund Gesamtkoderate eines kodierten und fehlergeschützten Informationsstroms angeglichen wird. Über die Punktierer- und Multiplexereinheit läßt sich insbesondere die gewünschte Gesamtkoderate einstellen, indem entsprechend punktiert wird.

Die Demultiplexer in den einzelnen Kodierzweigen dienen dazu, Symbole verschiedener Güteklassen in entsprechende Kodierzweige einzuspeisen. Zur Erzeugung eines ungleichen Fehlerschutzes können Symbole höherer Güteklassen, d.h. höherer Wichtigkeit, in einem Kodierzweig beispielsweise mit einer höheren Kodierrate mittels dreier Kodierer kodiert werden; Symbole niedriger Güteklassen, d.h. geringerer Wichtigkeit, können dann beispielsweise mit einer höheren Kodierrate mittels zwei Kodierern kodiert werden. In der Punktierer- und Multiplexereinheit können dann wiederum die unterschiedlich kodierten Symbole auf eine gemeinsame Gesamtkoderate von beispielsweise 1/3 (höhere Wichtigkeit) bzw. 1/2 (niedrigere Wichtigkeit) gebracht werden. Durch die Einstellung der Gesamtkoderate in der Punktierer- und Multiplexereinheit wird dann für den gesamten Informationsstrom eine gemeinsame Koderate eingestellt, obwohl die in dem Informationsstrom enthaltenen Symbole unterschiedlicher Güteklassen entsprechend unterschiedlich kodiert sind, d.h. eine unterschiedliche Kodeoder Kodierrate aufweisen. Vorteilhafterweise kann somit ein Informationsstrom mit Symbolen unterschiedlicher Güteklassen ohne ein Hin- und Her- oder Umschalten zwischen verschiedenen getrennten Kodierern verarbeitet werden. Der Informationsstrom wird sozusagen parallel in eine Vielzahl von unterschiedlichen oder auch gleichen Koderzweigen eingespeist und in der Punktierer- und Multiplexereinheit wieder zu einem fehlergeschützten Informationsstrom "zusammengesetzt".

Insbesondere sind der oder die Verschachteler Turbo-Kode-Verschachteler. Hierdurch wird ein besonders guter Fehlerschutz, insbesondere bei großen Blöcken mit mehr als tausend Bits, erzielt.

Vorzugsweise werden in jedem Kodierzweig die gegebenenfalls verschachtelten Symbole mittels eines Teilkodierers kodiert, wobei ein Teilkodierer ein rekursiver systematischer Faltungskodierer oder nichtsystematischer Faltungskodierer oder Block-Kodierer ist.

Die Teilkodierer weisen vorzugsweise eine gemeinsame Kodierrate auf. Alternativ können die Teilkodierer eine unterschiedliche Kodierrate aufweisen.

Ferner betrifft die Erfindung eine Vorrichtung zur Kanalkodierung in einem Nachrichtenübertragungssystem, wobei
- ein zu kodierender Informationsstrom Symbole verschiedener Güteklassen aufweist,
- der Informationsstrom einer Vielzahl von Kodierzweigen zur Kodierung zugeführt wird,
- jeder Kodierzweig einen Multiplexers aufweist, über den die Symbole verschiedener Güteklassen des Informationsstromes eingespeist werden,
- mindestens einem der Multiplexer ein Verschachteler zur Erzeugung eines Fehlerschutzes der gefilterten Symbole nachgeschaltet ist,
- jeder Kodierzweig einen Teilkodierer zum Kodieren der gefilterten und gegebenenfalls verschachtelten Symbole aufweist, und
- die von den Teilkodierern kodierten Symbole parallel einer Punktierer- und Multiplexereinheit zuführt werden.

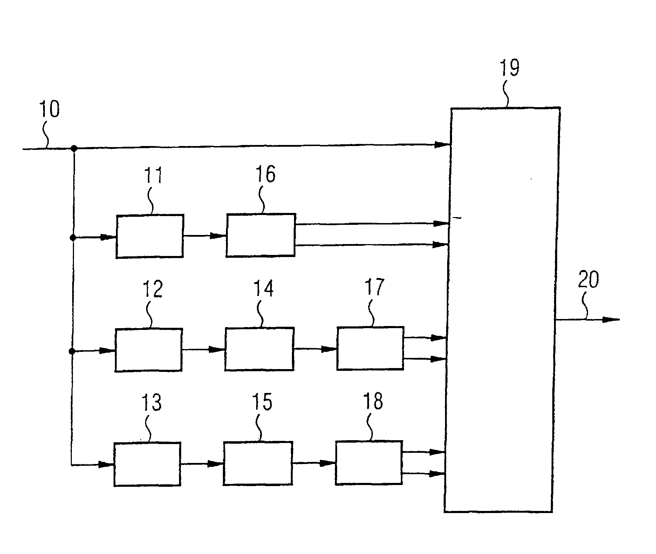

Weitere Vorteile der Erfindung ergeben sich aus der nachfolgenden Beschreibung von Ausführungsbeispielen in Verbindung mit der Zeichnung. In der Zeichnung ist ein erstes Ausführungsbeispiel eines Kodierers zur Durchführung des erfindungsgemäßen Verfahrens dargestellt.

Ein zu übertragender und kodierender Informationsstrom 10 weist Datenblöcke mit N Bits auf. Diese N Bits umfassen N1 und N2 Bits (N = N1 + N2). Die N2 Bits gehören einer ersten, höheren Güteklasse als die N1 Bits an. Beispielsweise können die N2 Bits zur Übertragung wichtiger Daten wie beispielsweise sicherheitsrelevanter Daten (PIN, Paßwort) dienen und die N1 Bits Sprachdaten entsprechen, bei denen kein so hoher Fehlerschutz wie beispielsweise bei sicherheitsrelevanten Daten benötigt wird.

Es werden weniger Bits der ersten, hohen Güteklasse als der zweiten, niedrigen Güteklasse übertragen, so daß gilt: N2 < N1.

Der zu übertragende und kodierende Informationsstrom 10 wird einer Punktierer- und Multiplexereinheit 19 zugeführt, die anhand des Informationsstroms beispielsweise die Anzahl der Symbole (hier Bits) unterschiedlicher Güteklasse und deren zeitliche Lage und Häufigkeit feststellt. Die Punktierer- und Multiplexereinheit 19 benötigt nämlich die Struktur des Informationsstromes 10 für die Verarbeitung aus verschiedenen Kodierzweigen.

Parallel wird der Informationsstrom einem ersten, zweiten und dritten Demultiplexer 11 bzw. 12 bzw. 13 zugeführt. Die Demultiplexer speisen Symbole verschiedener Güteklassen des Informationsstromes in die verschiedenen Kodierzweige ein. Im abgebildeten Ausführungsbeispiel sind drei Kodierzweige zum Kodieren von Symbolen vorgesehen.

Dem ersten Demultiplexer 11 ist ein erster Teilkodierer 16 nachgeschaltet, der Symbole bzw. Bits der niedrigsten Güteklasse kodiert. Die Ausgangssignale des ersten Teilkodierers 16 werden der Punktierer- und Multiplexereinheit 19 zugeführt.

Dem zweiten und dem dritten Demultiplexer 12 bzw. 13 ist jeweils ein erster bzw. zweiter Turbo-Kode-Verschachteler 14 bzw. 15 nachgeschaltet. Die Turbo-Kode-Verschachteler 14 und 15 bewirken eine Umordnung und zeitliche Spreizung der zugeführten Symbole bzw. Bits. Der Turbo-Kode-Verschachteler beeinflußt die freie Distanz eines Turbo-Kodes, der zur Kodierung der Symbole verwendet wird.

Dem ersten und zweiten Turbo-Kode-Verschachteler 14 bzw. 15 ist jeweils ein zweiter Teilkodierer 17 bzw. dritter Teilkodierer 18 nachgeschaltet. Der zweite und dritte Teilkodierer 17 und 18 ist jeweils als rekursiver systematischer Faltungskodierer (RSC-Coder: Recursive-Systematic-Convolutional-Coder) ausgeführt. RSC-Coder eignen sich insbesondere zusammen mit Turbo-Kode-Verschachtelern für Turbo-Kodes. Alternativ können der zweite Teilkodierer 17 oder der dritte Teilkodierer 18 auch als nichtsystematischer Faltungskodierer (NSC-Coder: Nonsystematic-Convolutional-Coder) oder als Block-Kodierer ausgeführt sein.

Die Ausgangssignale des zweiten und dritten Teilkodierers 17 bzw. 18 werden der Punktierer- und Multiplexereinheit 19 zugeführt, welche die Gesamtkoderate einstellt und einen kodierten und fehlergeschützten Informationsstrom 20 erzeugt, der einen ungleichen Fehlerschutz aufweist und einfach zu dekodieren ist.

In einem zweiten (nicht dargestellten) Ausführungsbeispiel weist eine Vorrichtung zur Durchführung des erfindungsgemäßen Verfahrens einen Turbo-Kode-Verschachteler und zwei gleiche Teilkodierer auf. Der Turbo-Kode-Verschachteler hat die Größe N = N1 + N2. Ein ungleicher Fehlerschutz wird hierbei durch eine unterschiedliche Punktierung der N1 Bits und der N2 Bits erreicht.

In einem dritten (nicht dargestellten) Ausführungsbeispiel weist eine Vorrichtung zur Durchführung des erfindungsgemäßen Verfahrens zwei unterschiedliche Teilkodierer mit einer ungleichen Koderate R1 < R2 auf. Weiterhin sind zwei Demultiplexer und ein Turbo-Kode-Verschachteler vorgesehen. Der erste Teilkodierer mit der niedrigeren Koderate R1 kodiert die N2 Bits höherer Güteklasse, der zweite Teilkodierer mit der höheren Koderate R2 die N1 Bits niedriger Güteklasse. Dadurch wird eine ungleiche Koderate und ein ungleicher Fehlerschutz erreicht.

## Patentansprüche

1. Verfahren zur Kanalkodierung in einem Nachrichtenübertragungssystem, wobei
- ein zu kodierender Informationsstrom (10) Symbole verschiedener Güteklassen aufweist,
- der Informationsstrom (10) einer Vielzahl von Kodierzweigen zur Kodierung zugeführt wird,
- in jedem Kodierzweig mittels eines Demultiplexers (11 - 13) die Symbole verschiedener Güteklassen des Informationsstromes (10) eingespeist werden,
- mindestens einem der Demultiplexer (11 - 13) ein Verschachteler (14, 15) zur Erzeugung eines Fehlerschutzes der Symbole nachgeschaltet ist,
- in jedem Kodierzweig die gegebenenfalls verschachtelten Symbole kodiert und die kodierten Symbole aus den Kodierzweigen parallel einer Punktierer- und Multiplexereinheit (19) zugeführt werden, und
- mit der Punktierer- und Multiplexereinheit (19) eine vorgebbare Koderate eingestellt wird.

2. Verfahren nach Anspruch 1, **dadurch gekennzeichnet, daß** der oder die Verschachteler (14, 15) Turbo-Kode-Verschachteler sind.

3. Verfahren nach Anspruch 1 oder 2, **dadurch gekennzeichnet, daß** in jedem Kodierzweig die gegebenenfalls verschachtelten Symbole mittels eines Teilkodierers (16 - 18) kodiert werden, wobei ein Teilkodierer (16 - 18) ein rekursiver systematischer Faltungskodierer oder nichtsystematischer Faltungskodierer oder Block-Kodierer ist.

4. Verfahren nach Anspruch 3, **dadurch gekennzeichnet, daß** die Teilkodierer (16 - 18) eine gemeinsame Kodierrate aufweisen.

5. Verfahren nach Anspruch 3, **dadurch gekennzeichnet, daß** die Teilkodierer (16 - 18) eine unterschiedliche Kodierrate aufweisen.

6. Vorrichtung zur Kanalkodierung in einem Nachrichtenübertragungssystem, wobei
- ein zu kodierender Informationsstrom (10) Symbole verschiedener Güteklassen aufweist,
- der Informationsstrom (10) einer Vielzahl von Kodierzweigen zur Kodierung zugeführt wird,
- jeder Kodierzweig einen Demultiplexer (11 - 13) aufweist, über den die Symbole verschiedener Güteklassen des Informationsstromes (10) eingespeist werden,
- mindestens einem der Demultiplexer (11 - 13) ein Verschachteler (14, 15) zur Erzeugung eines Fehlerschutzes der gefilterten Symbole nachgeschaltet ist,
- jeder Kodierzweig einen Teilkodierer (16 - 18) zum Kodieren der gefilterten und gegebenenfalls verschachtelten Symbole aufweist, und
- die von den Teilkodierern (16 - 18) kodierten Symbole parallel einer Punktierer- und Multiplexereinheit (19) zuführt werden.

## Claims

1. Method for channel coding in a message transmission system, in which
- an information stream (10) to be coded exhibits symbols of different quality classes,
- the information stream (10) is supplied to a multiplicity of coding branches for coding and in parallel to a puncturing and multiplexing unit (19),
- the symbols of different quality classes of the information stream (10) are fed into each coding branch by means of a demultiplexer (11 - 13),
- at least one of the demultiplexers (11 - 13) is followed by an interleaver (14, 15) for generating an error protection for the symbols,
- in each coding branch, the possibly interleaved symbols are coded and the coded symbols from the coding branches are supplied in parallel to a puncturing and multiplexing unit (19), and
- a predeterminable code rate is set with the puncturing and multiplexing unit (19).

2. Method according to Claim 1, **characterized in that** the interleaver or interleavers (14, 15) are turbo code interleavers.

3. Method according to Claim 1 or 2, **characterized in that** in each coding branch, the possibly interleaved symbols are coded by means of a fractional coder (16 - 18), a fractional coder (16 - 18) being a recursive systematic convolutional coder or nonsystematic convolutional coder or block coder.

4. Method according to Claim 3, **characterized in that** the fractional coders (16 - 18) exhibit a common coding rate.

5. Method according to Claim 3, **characterized in that** the fractional coders (16 - 18) have a different coding rate.

6. Device for channel coding in a message transmission system, in which
- an information stream (10) to be coded exhibits symbols of different quality classes,
- the information stream (10) is supplied to a multiplicity of coding branches for coding and, in parallel, to a puncturing and multiplexing unit (19),
- each coding branch has a demultiplexer (11 - 13) via which the symbols of different quality classes of the information stream (10) are fed in,
- at least one of the demultiplexers (11 - 13) is followed by an interleaver (14, 15) for generating an error protection of the filtered symbols,
- each coding branch exhibits a fractional coder (16 - 18) for coding the filtered and possibly interleaved symbols, and
- the symbols coded by the fractional coders (16 - 18) are supplied in parallel to a puncturing and multiplexing unit (19).

## Revendications

1. Procédé pour le codage de canal dans un système de transmission d'informations, dans lequel
- un flux d'informations à coder (10) comporte des symboles de différentes classes de qualité,
- on envoie le flux d'informations (10) à plusieurs branches de codage pour le codage,
- on introduit les symboles de différentes classes de qualité du flux d'informations (10) dans chaque branche de codage au moyen d'un démultiplexeur (11 à 13),
- un dispositif d'imbrication (14, 15) pour la production d'une protection contre les erreurs est branché du côté aval d'au moins l'un des démultiplexeurs (11 à 13),
- dans chaque branche de codage, on code les symboles éventuellement imbriqués et on envoie les symboles codés hors des branches de codage en parallèle à une unité de ponctuation et de multiplexage (19), et
- un facteur de code est réglé avec l'unité de ponctuation et de multiplexage (19).

2. Procédé selon la revendication 1, **caractérisé par le fait que** le ou les dispositifs d'imbrication (14, 15) sont des dispositifs d'imbrication à turbocode.

3. Procédé selon la revendication 1 ou 2, **caractérisé par le fait que**, dans chaque branche de codage, on code les symboles éventuellement imbriqués au moyen d'un codeur partiel (16 à 18), un codeur partiel (16 à 18) étant un codeur convolutif systématique récursif ou un codeur convolutif non systématique ou un codeur par blocs.

4. Procédé selon la revendication 3, **caractérisé par le fait que** les codeurs partiels (16 à 18) ont un facteur de code commun.

5. Procédé selon la revendication 3, **caractérisé par le fait que** les codeurs partiels (16 à 18) ont un facteur de code différent.

6. Dispositif pour le codage de canal dans un système de transmission de données, dans lequel
- un flux d'informations à coder (10) comporte des symboles de différentes classes de qualité,
- le flux d'informations (10) est envoyé à plusieurs branches de codage pour le codage,
- chaque branche de codage comporte un multiplexeur (11 à 13) par l'intermédiaire duquel sont introduits les symboles de différentes classes de qualité du flux d'informations (10),
- un dispositif d'imbrication (14, 15) pour la production d'une protection contre les erreurs des symboles filtrés est branché du côté aval d'au moins l'un des multiplexeurs (11 à 13),
- chaque branche de codage comporte un codeur partiel (16 à 18) pour coder les symboles filtrés et éventuellement imbriqués, et
- les symboles codés par les codeurs partiels (16 à 18) sont envoyés en parallèle à une unité de ponctuation et de multiplexage (19).
